Europäisches Patentamt

European Patent Office

Office européen des brevets

(11) Veröffentlichungsnummer: **0 220 473**
A2

# EUROPÄISCHE PATENTANMELDUNG

(21) Anmeldenummer: 86112897.3

(22) Anmeldetag: 18.09.86

(51) Int. Cl.⁴: **H 05 K 13/00**

(30) Priorität: 17.10.85 DE 3537010

(43) Veröffentlichungstag der Anmeldung: 06.05.87 Patentblatt 87/19

(84) Benannte Vertragsstaaten: AT BE CH DE FR GB IT LI LU NL SE

(71) Anmelder: Siliner, Georg, Buchenstrasse 23, D-8411 Zeitlam (DE)

(72) Erfinder: Siliner, Georg, Buchenstrasse 23, D-8411 Zeitlam (DE)

(74) Vertreter: Graf, Helmut, Dipl.-Ing. et al, Patentanwälte Dipl.-Ing. A. Wasmeier Dipl.-Ing. H. Graf Greflinger Strasse 7 Postfach 382, D-8400 Regensburg (DE)

(54) System zum Transportieren und Führen von Bauteilen, insbesondere elektrischen Bauelementen, die in radial oder quasi-radial gegurteter Form an einem Gurt gehalten sind.

(57) Die Erfindung bezieht sich auf ein System zum Transportieren und Führen von Bauteilen, insbesondere elektrischen Bauelementen entlang einer Führung, wobei die Bauteile in radial oder in quasi-radial gegurteter Form an einem Gurt mit einer Perforation gehalten sind, die von einer Vielzahl durch Stanzen oder Schneiden im Gurt erzeugten Perforationsöffnungen gebildet ist.

Die Erfindung zeichnet sich dadurch aus, daß die Perforationsöffnungen jeweils durch eine nicht vollständig in sich geschlossene Schnittlinie hergestellt sind und somit der Gurt im Bereich jeder Perforationsöffnung einen durch die Schnittlinie gebildeten Lappen aufweist, daß jeder Lappen derart aus der Ebene des Gurtes nach außen gedrückt ist, daß er mit seinem freien Ende über eine Oberflächenseite des Gurtes seitlich vorsteht, und daß die freien Enden der Lappen Anlageflächen bilden, die an wenigstens einer quer bzw. senkrecht zur Gurtebene sowie in Gurtlängsrichtung verlaufenden Führungsfläche der Führung anliegen.

EP 0 220 473 A2

0220473

**System zum Transportieren und Führen von Bauteilen, insbesondere elektrischen Bauelementen, die in radial oder quasi-radial gegurteter Form an einem Gurt gehalten sind**

Die Erfindung bezieht sich auf ein System gemäß Oberbegriff Patentanspruch 1.

Es ist allgemein üblich, insbesondere elektrische Bauelemente, wie beispielsweise Widerstände, Kondensatoren usw. in radial bzw. in quasi-radial gegurteter Form an einem mit einer Perforation versehenen Gurt in jeweils gleichmäßigen Abständen in Gurtlängsrichtung zu befestigen, um die so gegurteten Bauteile für eine Be- oder Verarbeitung innerhalb einer Vorrichtung oder Anlage in einer durch die Gurtung jeweils vorgegebenen Orientierung transportieren zu können. Zum Transport dienen Transportelemente, vorzugsweise Transporträder oder Scheiben, die an ihrem Außenumfang mit einer Vielzahl von Vorsprüngen oder Stiften versehen sind, welche in die vollständig ausgestanzten Perforationsöffnungen des Gurtes eingreifen. Die in die Perforationsöffnungen eingreifenden Stifte der Transportelemente dienen auch gleichzeitig dazu, um eine lagegenaue Führung des Gurtes zu erzielen.

Die bekannten Systeme haben insbesondere den Nachteil, daß der die Bauteile tragende und beispielsweise in einem Magazin einer Vorrichtung bereitstehende Gurt zwangsläufig nur eine begrenzte Länge aufweist, die beispielsweise durch das Fassungsvermögen des Magazins vorgegeben ist, d.h. während der Be- oder Verarbeitung der Bauelemente (beispielsweise beim Aufbringen einer Ummantelung aus isolierendem Material auf dem Bauelementekörper oder aber beim Zuführen der Bauelemente an die Bestückungsstation eines Bestückungsautomaten beispielsweise zum Bestücken von elektrischen Schaltungen oder Print-Platten) muß an das in Bewegungsrichtung des Gurtes hintere Ende eines Gurtes von Zeit zu Zeit das vordere Ende (Anfang) eines neuen Gurtes angeschlossen werden, und zwar derart, daß auch im Anschlußbereich der Abstand der Perforationslöcher gleich demjenigen Abstand ist, den diese Perforationslöcher ansonsten in Gurtlängsrichtung aufweisen. Dies bedeutet, daß an das Ende eines im Arbeitsprozeß befindlichen Gurtes der Anfang eines neuen Gurtes sehr genau, beispielsweise durch Festkleben z.B. mit Hilfe eines Klebestreifens usw. angeschlossen bzw. befestigt werden muß, um ein vollständiges neues Einfädeln des Gurtes in die Be-oder Verarbeitungseinrichtung zu vermeiden. Dieses Anschließen eines neuen Gurtes setzt in der Regel eine Unterbrechung des Arbeitsprozesses voraus. Die gleiche Situation ergibt sich dann, wenn der in einem Arbeitsprozeß befindliche Gurt durch Fehlverhalten der Vorrichtung oder durch Fehler bei der Bedienung usw. reißt.

Der Erfindung liegt die Aufgabe zugrunde, ein System aufzuzeigen, mit welchen es möglich ist, Gurte fortlaufend nacheinander einem Arbeitsprozeß zuzuführen, ohne daß ein Anschließen der einzelnen Gurte durch Verbinden dieser Gurte notwendig ist, und ohne daß es vor allem auch notwendig ist, beim Anschließen eines Gurtes an das Ende eines im Arbeitsprozeß befindlichen Gurtes darauf zu achten, daß im Anschlußbereich der Abstand der Perforationsöffnungen genau dem Abstand entspricht, den diese Öffnungen entlang des Gurtes sonst aufweisen.

Zur Lösung dieser Aufgabe ist ein System entsprechend dem kennzeichnenden Teil des Patentanspruches 1 ausgebildet.

Das erfindungsgemäße System hat zunächst den Vorteil, daß die Gurte für die Bauteile auch in solchen Einrichtungen verwendet werden können, die zum Transport und zur besonders genauen Positionierung des Gurtes Transportelemente mit in die Perforation des Gurtes eingreifenden Stiften aufweisen.

Das erfindungsgemäße System hat weiterhin den Vorteil, daß die am Gurt vorgesehenen Lappen mit ihren freien Enden Führungsflächen für den Gurt in der verwendeten Führung bzw. in den verwendeten Führungen bilden, so daß es vor allem möglich ist, an das Ende eines im Arbeitsprozeß befindlichen Gurtes den Anfang eines neuen Gurtes dadurch anzuschließen, daß dieser mit seinem Anfang lediglich in eine Führung soweit eingeschoben wird, bis der Gurt von einer Transporteinrichtung erfaßt und automatisch weitergefördert wird. Ein exaktes Anschließen und dabei insbesondere auch ein Verkleben des Endes eines Gurtes mit dem Anfang eines neuen Gurtes ist bei dem erfindungsgemäßen System nicht erforderlich. Die Gurte können daher ohne Unterbrechung des Arbeitsprozesses nacheinander zugeführt werden.

Bei einer bevorzugten Ausführungform sind die mit ihrer Längserstreckung bzw. ihrer Fläche schräg zur Ebene bzw. zu den Oberflächenseiten des Gurtes liegenden Lappen durch entsprechende Wahl der Schnittlinie derart ausgebildet, daß die freien Enden dieser Lappen jeweils einer Längskante des Gurtes zugewendet sind. Hierdurch ist eine besonders sichere und zuverlässige Führung für den Gurt erreicht, da beispielsweise ev. senkrecht zu dieser Längskante des Gurtes (von dieser Längskante) nach außen wirkende Zugkräfte von den die wenigstens eine Führungsfläche der Führung widerhakenartig hintergreifenden Lappen sicher und zuverlässig aufgenommen werden, wobei die Lappen durch die erwähnten Kräfte auch nicht soweit zur Seite gebogen werden können, daß sie etwa außer Eingriff mit der wenigstens einen Führungsfläche kommen, da die Führung zugleich auch eine seitliche, das Ausweichen der Lappen verhindernde Anlage für die Lappen bildet.

Das erfindungsgemäße System ist überall dort einsetzbar, wo an einem Gurt befestigte Bauteile für eine Be- und Verarbeitung zusammnen mit dem Gurt in Gurtlängsrichtung transportiert werden müssen. Ein Anwendungsbeispiel für das erfindungsgemäße System besteht beispielsweise beim Aufbringen einer Ummantelung aus isolierendem Material auf die Bauelementekörper elektrischer Bauelemente. Hierbei werden die vom Gurt nach unten hängenden Bauelemente zusammen mit dem Gurt beispielsweise über eine erste geradlinige Führung einem halbkreisförmig ausgebildeten Führungs- und Transportabschnitt schräg von oben zugeführt, unter welchem vorzugsweise ein rotierend umlaufender und als Ring-Wanne ausgebildeter Behälter für das die Ummantelung bildende Material angeordnet ist. Beim Passieren des kreisbogenförmigen Führungs- und Transportabschnittes tauchen die Bauelemente mit ihrem Bauelementekörpern zunächst zunehmend in das die Ummantelung bildende Material ein und werden anschließend wieder aus diesem Material herausgehoben. An das Ende des Führungs- und Transportabschnittes schließt sich dann beispielsweise eine zweite geradlinige Führung an, in welcher der Gurt zusammen mit den an diesem Gurt gehaltenen Bauelementen schräg nach oben weggeführt wird und einer weiteren Bearbeitung, beispielsweise zum Trocknen oder Aushärten des die Ummantelung bildenden Materials und/oder zum Aufbringen einer weiteren Schicht aus isolierendem Material zugeführt wird.

Weiterbildungen der Erfindung sind Gegenstand der Unteransprüche.

Die Erfindung wird nachfolgend im Zusammenhang mit den Figuren an Ausführungsbeispielen näher erläutert. Es zeigen:

Fig. 1 in Seitenansicht einen Gurt des erfindungsgemäßen Systems zusammen mit den an diesem Gurt befestigten, quasi radial gegurteten Bauelementen;

Fig. 2 einen Querschnitt durch den Gurt gemäß Fig. 1 sowie durch ein Führungs- und Transportelement;

Fig. 3 eine Teillänge des Führungs- und Transportelementes der Fig. 2, zusammen mit einer Teillänge des in diesem Element geführten Gurtes und einer zur Fortbewegung des Gurtes dienenden Transporteinrichtung;

Fig. 4 eine Draufsicht auf eine Teillänge des Führungs- und Transportelementes im Bereich der Transporteinrichtung;

Fig. 5 einen Schnitt entsprechend der Linie I-I der Fig. 4;

Fig. 6 in Draufsicht eine weitere Ausführungsform des Führungs-und Transportelementes;

Fig. 7 einen Schnitt entsprechend der Linie II-II der Fig. 6;

Fig. 8 einen Schnitt entsprechend der Linie III-III der Fig. 6.

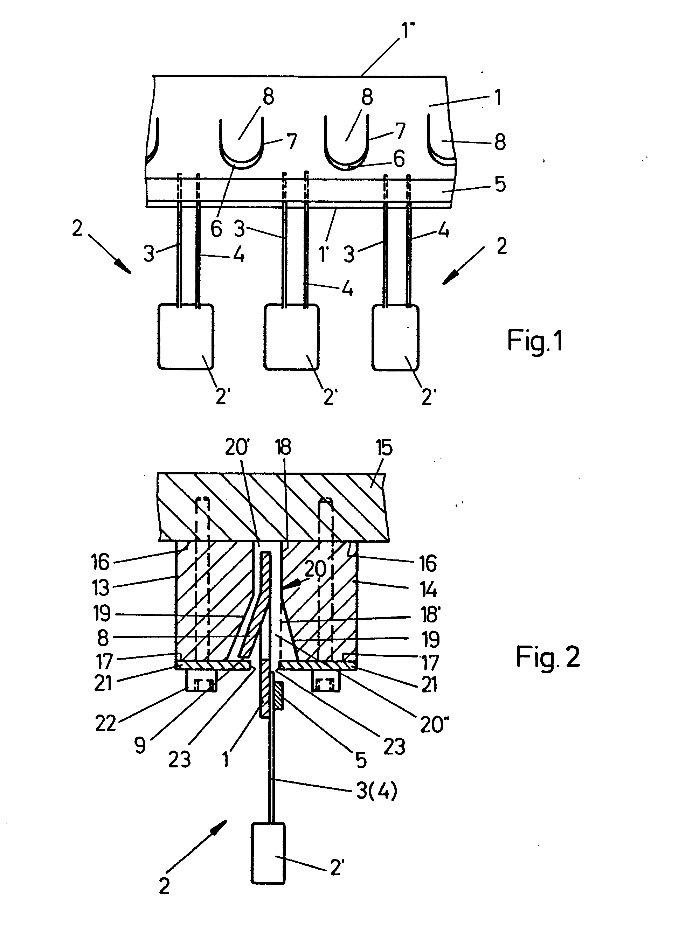

In den Figuren ist 1 ein Gurt, der in an sich bekannter Weise von einem streifenförmigen Zuschnitt aus verstärktem Papier oder anderem geeigneten Flachmaterial gebildet ist. An dem Gurt 1 sind in ebenfalls an sich bekannter Weise in jeweils gleichmäßigen Abständen voneinander elektrische Bauelemente 2 mit den Enden ihrer Anschlußdrähte 3 und 4 derart gehalten, daß die Anschlußdrähte 3 und 4 sämtlicher Bauelemente 2 senkrecht zur Längserstreckung des Gurtes 1 liegen und die Anschlußdrähte 3 und 4 zusammen mit den Bauelementekörpern 2' über eine gemeinsame Längsseite, d.h. bei der für die Fig. 1 gewählten Darstellung über die untere Längsseite 1' des Gurtes 1 wegstehen. Die Bauelemente 2 sind also in quasi radialer Form am Gurt 1 gehalten, und zwar dadurch, daß die in der Fig. 1 oberen, an einer Oberflächenseite des Gurtes 1 anliegenden Enden der Anschlußdrähte 3 und 4 dort durch ein durchgehendes Klebeband 5 oder auf andere geeignete Weise befestigt sind.

Zwischen zwei Bauelementen 2 ist jeweils eine Perforationsöffnung 6 vorgesehen, die zusammen mit den anderen, gleichartig ausgebildeten Perforationsöffnungen 6 eine in Gurtlängsrichtung verlaufende Perforation bildet, mit der es beispielsweise unter Verwendung von Transporträdern mit in diese Perforation eingreifenden Stiften möglich ist, den Gurt 1 besonders genau einer Arbeitsstation z.B. zum Verarbeiten der Bauelemente 2, beispielsweise einer Bestückungsstation usw. zuzuführen.

Im Gegensatz zu den üblichen Perforationsöffnungen, die vollständig ausgestanzt sind, ist jede Perforationsöffnung 6 des Gurtes 1 dadurch hergestellt, daß mit Hilfe eines geeigneten Stanzwerkzeuges eine nicht vollständig in sich geschlossene Schnittlinie 7, d.h. bei der dargestellten Ausführungsform eine Schnittlinie 7 mit U-förmigem Verlauf erzeugt wird, und zwar derart, daß der nicht geschlossene Bereich dieser Schnittlinie der den Bauelementen 2 entfernt liegenden Längskante 1", d.h. bei der für die Fig. 1 gewählten Darstellung der oberen Längskante 1" des Gurtes 1 näher liegt als der Längskante 1'. Durch die nicht vollständig geschlossene Schnittlinie 7 wird beim Ausstanzen jedes Perforationsloches 6 jeweils ein mit dem Gurt 1 einstückiger Lappen 8 erzeugt, dessen freies Ende 9 der Längskante 1´ zugewendet ist und der beim Ausstanzen bzw. beim Erzeugen der Schnittlinie 7 gleichzeitig so nach außen gedrückt wird, daß die Lappen 8 sämtlicher Perforationsöffnungen 6 schräg zu den Oberflächenseiten des Gurtes 1 liegen und zumindest mit ihren freien Enden 9 wenigstens geringfügig über eine gemeinsame Oberflächenseite, d.h. bei der für die Fig. 2 gewählten Darstellung über die linke Oberflächenseite des Gurtes 1 vorstehen.

Durch die Lappen 8 bietet sich die Möglichkeit, den Gurt 1 insbesondere mit von diesem Gurt nach unten hängenden Bauelementen 2 in einem Führungs- und Transportelement zu führen und in Gurtlängsrichtung zu bewegen, um beispielsweise die Bauelemente 2 bestimmten Be- oder Verarbeitungsvorgängen zuzuführen, ohne daß zur Halterung und Fortbewegung des Gurtes 1 in die Perforation des Gurtes eingreifende Transportelemente, z.B. Transporträder mit in die Gurtperforation eingreifenden Stiften erforderlich sind. Durch die Perforationsöffnungen 6 ist der Gurt 1 jedoch auch für die Verwendung von in die Perforation eingreifenden Transportelementen geeignet.

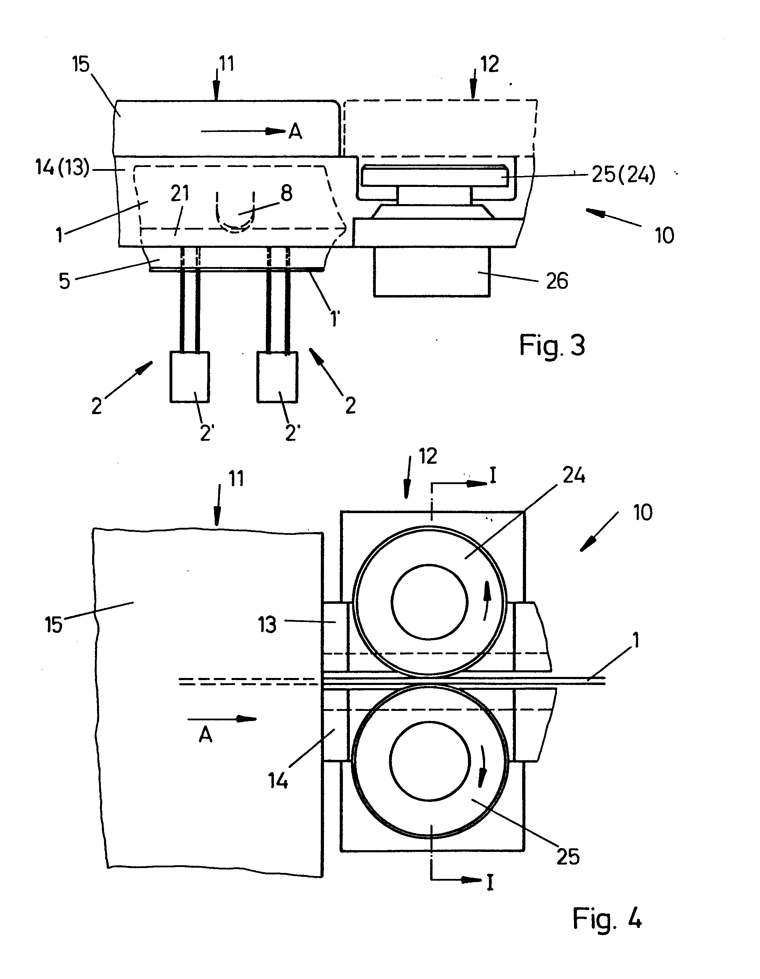

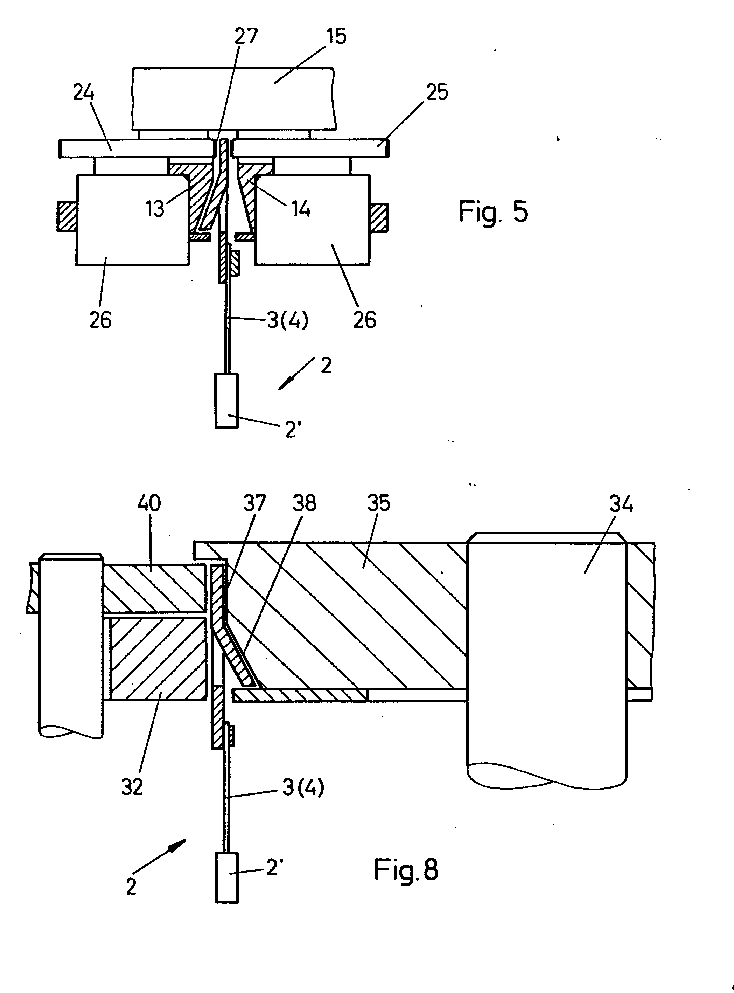

Ein Führungs- und Transportelement, welches unter Ausnutzung der Lappen 8 die Führung und den Transport des Gurtes 1 in Gurtlängsrichtung gestattet, ist in den Figuren 2 bis 5 dargestellt. Dieses geradlinig ausgebildete Führungs- und Transportelement 10 besteht aus wenigstens einer geradlinigen Führung 11 und aus wenigstens einer an einem Ende dieser Führung angeordneten Förder- oder Transporteinrichtung 12, wobei je nach Erfordernissen am Anfang und am Ende der Führung 11 jeweils eine Transporteinrichtung 12 vorgesehen sein kann und/oder auch mehrere Führungen 11 ggf. jeweils mit dazwischenliegenden Transporteinrichtungen 12 aufeinanderfolgen können. Grundsätzlich ist es weiterhin auch möglich, die Führung 11 nicht nur geradlinig, sondern zumindest auf einer Teillänge auch beliebig gekrümmt auszubilden.

Unabhängig davon, ob die Führung 11 geradlinig oder zumindest in einem Teilbereich gekrümmt ausgebildet ist, besteht diese Führung aus zwei parallel zueinander angeordneten Führungsleisten 13 und 14, die an der Unterseite einer Halteplatte 15 befestigt sind. Wie die Fig. 2 zeigt, sind die Führungsleisten 13 und 14 im Querschnitt so ausgebildet, daß sie jeweils eine obere, horizontale und gegen die Unterseite der Halteplatte 15 anliegende Fläche 16, eine untere, ebenfalls horizontale und damit parallel zur Fläche 16 liegende Fläche 17 und an ihren einander zugewendeten Seiten eine Fläche aufweisen, die sich aus jeweils einem oberen, vertikalen und senkrecht zur Fläche 16 verlaufenden Flächenabschnitt 18 und aus einem sich daran nach unten anschließenden schräg verlaufenden Flächenabschnitt 19 zusammensetzt.

Die beiden Führungsleisten 13 und 14 sind so im Abstand voneinander an der Unterseite der Halteplatte 15 befestigt, daß sie zwischen sich einen durch die Halteplatte 15 nach oben hin geschlossenen Führungskanal 20 für den Gurt 1 bilden, wobei dieser Führungskanal 20 einen oberen, unmittelbar an die Halteplatte 15 angrenzenden Abschnitt 20' aufweist, der seitlich durch die Flächenabschnitte 18 der beiden im Querschnitt spiegelsymmetrisch zur vertikalen Mittelebene des Führungskanals 20 ausgebildeten Führungsleisten 13 und 14 begrenzt ist und dessen Breite in horizontaler Richtung und in Richtung senkrecht zur Längserstreckung des Gurtes 1 etwas größer ist als die Dicke des Gurtes. An den Abschnitt 20' schließt sich nach unten hin ein Abschnitt 20" an, in welchem die Breite des Führungskanales 20 aufgrund der beiden schrägen Flächenabschnitte 19 nach unten hin keilförmig zunimmt. Der Übergang zwischen den Flächenabschnitten 18 und 19 liegt etwa dort, wo bei in der Führung 11 eingeführtem Gurt sich der nicht geschlossene Teil der Schnittlinie 7, d.h. die Wurzel der Lappen 8 der Perforationsöffnungen 6 befindet, wobei die Neigung der Flächenabschnitte 19 gegenüber den Flächenabschnitten 18 etwa der Neigung entspricht, die die Lappen 8 gegenüber den Oberflächenseiten des Gurtes 1 aufweisen. An der unteren Fläche 17 der Führungsleisten 13 und 14 ist jeweils eine aus Flachmaterial bestehende leistenförmige Führungsschiene 21 mit der Oberseite an der Fläche 17 anliegend befestigt, und zwar mit Hilfe von Schrauben 22, die gleichzeitig auch zur Befestigung der Führungsleisten 13 und 14 an der Halteplatte 15 dienen. Die beiden Führungsschienen 21 weisen an ihren einander zugewendeten und parallel zueinander verlaufenden sowie in Längsrichtung der Führung liegenden Längskanten 23 einen gegenseitigen Abstand voneinander auf, der etwa gleich oder geringfügig größer ist als die Dicke des Gurtes 1, so daß zwischen diesen Längskanten 23 nochmals ein zusätzlicher Führungsspalt für den Gurt 1 gebildet ist. Wie die Fig. 2 zeigt, bildet die eine Führungsschiene 21 mit ihrer Oberseite im Bereich der Längskanten 23 eine Auflagefläche für das freie Ende 9 der Lappen 8 des Gurtes 1, der auf diese Weise in der Führung 11 gehalten ist und mit den auf der Oberseite der einen Führungsschiene 21 gleitenden Lappen 8 entlang dieser Führungsschiene verschoben werden kann. Mit dem unterhalb der Perforationsöffnungen liegenden Teil reicht der Gurt 9 durch die von den beiden Längskanten 23 gebildete schlitzförmige Öffnung (Führungsspalt) hindurch, so daß insbesondere auch die Bauelemente 2 unterhalb der Führung 11 frei zugänglich hängend am Gurt 1 gehalten sind. Die symmetrische Querschnittsausbildung der Führungsleisten 13 und 14 und die Verwendung von zwei Führungsschienen 21 hat den Vorteil, daß in der Führung 11 auch Gurte 1 geführt werden können, deren Lappen 8 abweichend von der Darstellung der Fig. 2 über die in dieser Figur rechte Oberflächenseite des Gurtes 1 vorstehen.

Zum Bewegen des Gurtes 1 entlang der Führung 11 (Pfeil A) dient die Transporteinrichtung 12, die im wesentlichen von zwei Walzen oder Scheiben 24 und 25 gebildet ist, die zumindest an ihrer Umfangsfläche mit einem Reibbelag aus elastischem Material versehen und um vertikale Achsen drehbar gelagert sind. Zumindest eine Scheibe ist durch einen Antrieb 26 um die vertikale Achse rotierend angetrieben. Die beiden Scheiben 24 und 24 weisen jeweils eine Höhe auf, die gleich oder geringfügig kleiner ist als der Abstand zwischen der Längskante 1" und der Wurzel der Lappen 8. Außerdem sind die Scheiben 24 und 25 so angeordnet, daß diese zwischen sich einen Förderspalt 27 bilden, der in Förderrichtung (Pfeil A) auf den Abschnitt 20′ des Führungskanales 20 der vorausgehen-

9    0220473

den Führung 11 folgt, d.h. der durch den Förderspalt 27 hindurchgeführte Gurt 1 wird von den Scheiben 24 und 25 nur im Bereich seiner oberen Längskante 1" oberhalb der Perforationsöffnungen 6 erfaßt, so daß vor allem auch die nach außen gedrückten Lappen 8 nach dem Passieren der Transporteinrichtung 12 für eine weitere Führung des Gurtes 1 erhalten bleiben. Auch im Bereich der Transporteinrichtung 12 ist selbstverständlich eine Führung für den Gurt entsprechend der Ausbildung nach Fig. 2 vorgesehen, wobei lediglich die oberen Flächenabschnitte 18 bzw. dieser Teil der entsprechenden Führungselemente für die Scheiben 24 und 25 ausgespart ist.

Der Transport bzw. die Bewegung des Gurtes 1 kann auch auf andere Weise erzielt werden, beispielsweise dadurch, daß anstelle der Scheiben 24 und 25 gegenläufig umlaufende Transportbänder vorgesehen sind, die mit zwei parallel zueinander verlaufenden und im Abstand voneinander angeordneten Längen den Förderspalt 27 zwischen sich bilden, oder aber dadurch, daß die Führung 11 Bestandteil eines Vibrations-Linearförderers ist.

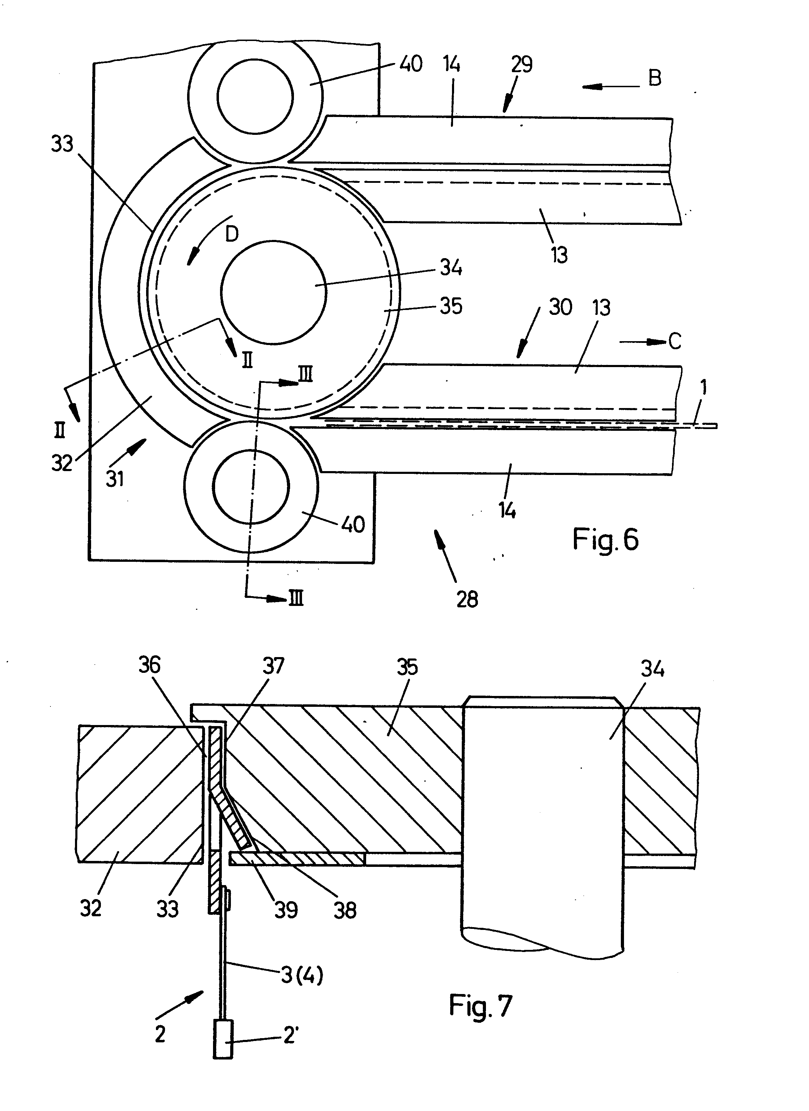

Eine weitere Ausbildung der Führungs- und Transporteinrichtung ist in den Fig. 7 bis 8 dargestellt. Diese Führungs- und Transporteinrichtung 28 ist so ausgebildet, daß der Gurt 1 mit den wiederum von der unteren Längskante 1´ nach unten hängenden Bauelementen 2 dem in der Fig. 6 oberen rechten Ende der Einrichtung in Richtung des Pfeiles B zugeführt und diese Einrichtung an dem in der Fig. 6 unteren rechten Ende in Richtung des Pfeiles C wieder verläßt, der Gurt 1 in der Einrichtung 28 also umgelenkt wird.

Am Einlauf sowie am Auslauf weist die Einrichtung 28 jeweils eine geradlinige Führung 29 bzw. 30 auf, die in ihrer Ausbildung der Führung 11 entspricht, allerdings mit dem Unterschied, daß lediglich die an den beiden einander zugewendeten Längsseiten der Führungen 29 und 30 angeordneten Führungsleisten 13 die schrägen Flächenabschnitte 19 aufweisen, während die an den beiden abgewendeten Längsseiten der Führungen 29 und 30 angeordneten Führungsleisten 14 die schrägen Flächenabschnitte 19 nicht aufweisen, sondern dort der vertikale Flächenabschnitt 18 von der Oberseite 16 bis zur Unterseite 17 der Führungsleiste 14 reicht, wie dies in der Fig. 2 mit der unterbrochene Linie 18´ angedeutet ist. Die beiden Führungen 29 und 30 sind über eine halbkreisförmige Führung 31 mit Transporteinrichtung miteinander verbunden, wobei die beiden äußeren Führungsleisten 14 bzw. deren Führungsflächen 18´ jeweils in das eine Ende einer als Führungsbogen ausgebildeten Führungsleiste 32 bzw. deren innere kreisbogenförmige Führungsfläche 33 übergehen. Die als Führungsbogen ausgebildete Führungsleiste 32 umschließt einen um die Achse 34 in Richtung des Pfeiles D rotierend angetriebenen Transportteller derart, daß zwischen der Führungsfläche 33 und der Umfangsfläche des Transporttellers 35 ein Führungs-und Transportspalt 36 für den Gurt 1 gebildet ist. Dadurch, daß die Umfangsfläche des Transporttellers im oberen Bereich kreiszylinderförmig, d.h. konzentrisch zur Welle 34 und Führungsfläche 33 und in einem sich daran nach unten anschließenden Bereich kegelstumpfförmig mit einem sich zur Unterseite des Transporttellers zunehmend verminderndem Querschnitt ausgebildet ist und außerdem an der Unterseite des Transporttellers 35 eine Scheibe oder ein Ring 39 befestigt ist, die bzw. der mit seiner radial außen liegenden Kante den gleichen Abstand von der Achse 34 aufweist wie der Bereich 37, ergibt sich ein Führungs- und Transportspalt 36, dessen Querschnitt dem Querschnitt des Führungskanals in den Führungen 29 und 30 entspricht und in dem der Gurt 1 durch die sich auf der Oberseite des Ringes 39 abstützenden Lappen 8 gehalten ist. Die Umfangsfläche des Transporttellers 35 ist vorzugsweise aus einem Material mit hohem Reibungskoeffizienten hergestellt.

Am Übergang zwischen den Führungen 29 und 30 und der Führung 31 sind zwei Andrückrollen 40 um vertikale Achsen drehbar gelagert. Die Andrückrollen 14 weisen eine solche Höhe auf und sind derart angeordnet, daß sie wie die Scheiben 24 und 25 nur auf den oberen Bereich des Gurtes 1 zwischen der oberen Längskante 1" und den Wurzeln bzw. Fußpunkten der Lappen 8 einwirken. Es versteht sich, beim Drehen des Transporttellers 35 in Richtung des Pfeiles D der mit dem vorderen Ende in die Führung 29 (beispielsweise von Hand) eingeschobene Gurt von dem Transportteller 35 erfaßt und dann fortlaufend am Einlauf der Führung 29 nachgezogen und am Auslauf der Führung 30 ausgeschoben wird.

Die Erfindung wurde voranstehend an Ausführungsbeispielen beschrieben. Es versteht sich, daß Änderungen sowie Abwandlungen möglich sind, ohne daß dadurch der der Erfindung zugrundeliegende Erfindungsgedanke verlassen wird.

**P a t e n t a n s p r ü c h e**

1. System zum Transportieren und Führen von Bauteilen, insbesondere elektrischen Bauelementen entlang einer Führung, wobei die Bauteile in radial oder in quasi-radial gegurteter Form an einem Gurt mit einer Perforation gehalten sind, die von einer Vielzahl durch Stanzen oder Schneiden im Gurt erzeugten Perforationsöffnungen gebildet ist, dadurch gekennzeichnet, daß die Perforationsöffnungen (6) jeweils durch eine nicht vollständig in sich geschlossene Schnittlinie (7) hergestellt sind und somit der Gurt (1) in Bereich jeder Perforationsöffnung (6) einen durch die Schnittlinie (7) gebildeten Lappen (8) aufweist, daß jeder Lappen (8) derart aus der Ebene des Gurtes (1) nach außen gedrückt ist, daß er mit seinem freien Ende (9) über eine Oberflächenseite des Gurtes (1) seitlich vorsteht, und daß die freien Enden (9) der Lappen (8) Anlageflächen bilden, die an wenigstens einer quer bzw. senkrecht zur Gurtebene sowie in Gurtlängsrichtung verlaufenden Führungsfläche (21, 39) der Führung (11, 29, 30, 31) anliegen.

2. System nach Anspruch 1, dadurch gekennzeichnet, daß die Schnittlinien (7) für die Perforationsöffnungen (6) jeweils derart ausgeführt sind, daß die freien Enden (9) der Lappen (8) jeweils einer Längskante (1´, 1´´) des Gurtes (1) zugewendet sind.

3. System nach Anspruch 2, dadurch gekennzeichnet, daß die freien Enden (9) der Lappen (8) jeweils derjenigen Längskante (1´) des Gurtes (1) zugewendet sind, über die die radial bzw. quasi-radial gegurteten Bauteile (2) vom Gurt (1) seitlich wegstehen.

4. System nach Anspruch 3, dadurch gekennzeichnet, daß der Gurt (1) mit den von diesem Gurt nach unten hängenden Bauteilen (2) in der Führung (11, 29, 30, 31) geführt ist.

5. System nach einem der Ansprüche 1 bis 4, dadurch gekennzeichnet, daß die Führung (11, 29, 30, 31) einen Führungskanal (20, 36) zur Aufnahme des Gurtes (1) aufweist, und daß die Lappen (8) im Inneren des Führungskanals (20, 36) angeordnet sind und die wenigstens eine Führungsfläche (21, 39) widerhakenartig hintergreifen.

6. System nach Anspruch 5, dadurch gekennzeichnet, daß der Führungskanal (20, 36) einen ersten Abschnitt besitzt, dessen Breite in etwa gleich oder größer ist als die Dicke des Gurtes (1), sowie einen sich an den ersten Abschnitt (20´) anschließenden zweiten Abschnitt (20´´) besitzt, in welchem der Führungskanal an wenigstens einer in Gurtlängsrichtung bzw. in Führungskanallängsrichtung verlaufenden Seite durch eine Ausnehmung verbreitert ausgebildet ist, und daß an der Übergangsstelle zwischen dem ersten und dem zweiten Abschnitt (20´, 20´´) und/oder an der dem ersten Abschnitt (20´) entfernt liegenden Seite des zweiten Abschnittes (20´´) die Führungsfläche (21, 39) für die freien Enden (9) der Lappen (8) gebildet ist.

7. System nach Anspruch 6, dadurch gekennzeichnet, daß die Lappen (8) mit ihrer Längserstreckung schräg zu den Oberflächenseiten bzw. zur Ebene des Gurtes (1) liegen, und daß der zweite Abschnitt (20´´) des Führungskanals (20, 36) in einer senkrecht zur Längserstreckung des Gurtes (1) bzw. zur Längserstreckung der Führung verlaufenden Querschnittsebene eine Querschnitt aufweist, dessen Breite sich zu der wenigstens einen Führungsfläche hin vorzugsweise keilförmig vergrößert.

8. System nach einem der Ansprüche 1 bis 7, gekennzeichnet durch wenigstens eine Transporteinrichtung (12, 31) für den Gurt (1) im Bereich der Führung.

9. System nach Anspruch 8, dadurch gekennzeichnet, daß die Transporteinrichtung (12, 31) wenigstens ein umlaufend angetriebenes Transportelement (24, 25; 35, 40) aufweist, welches eine umlaufende Anlagefläche für den Gurt (1) bildet und mit dieser Anlagefläche einen Förder- oder Transportspalt (27, 36) an einer Seite begrenzt, durch welchen der Gurt (1) hindurchgeführt ist.

10. System nach Anspruch 9, dadurch gekennzeichnet, daß das umlaufende Transportelement wenigstens eine Walze oder Scheibe (24, 25), vorzugsweise zwei gegenläufig umlaufenden Walzen oder Scheiben (24, 25) aufweist, die zwischen sich den Transportspalt (27) bilden.

11. System nach Anspruch 9 oder 10, dadurch gekennzeichnet, daß das umlaufende Transportelement ein Transportteller (35) ist, dessen Umfangsfläche mit einem dem Transportteller teilweise umschließenden Führungsbogen (32) den gleichzeitig auch als Transport- oder Förderspalt dienenden Führungskanal (36) bildet.

12. System nach einem der Ansprüche 9 bis 11, dadurch gekennzeichnet, daß zusätzlich zu dem umlaufenden Transportelement (35) wenigstens eine den Gurt gegen das Transportelement andrückende Andrückwalze oder -scheibe (40) vorgesehen ist.

Fig.1

Fig. 2

Fig. 3

Fig. 4

Fig. 5

Fig. 8

Fig. 6

Fig. 7